# EUROPÄISCHE PATENTSCHRIFT

(11) **EP 2 169 735 B1**
(45) Veröffentlichungstag und Bekanntmachung des Hinweises auf die Patenterteilung: **23.01.2013**
(21) Anmeldenummer: 09170659.8
(22) Anmeldetag: 18.09.2009
(51) Int. Cl.: H01L 39/14, H01L 39/24

(54) **Supraleitender Verbund sowie Verfahren zum Herstellen derselben**
Superconductive compound and method for producing same
Composite supraconducteur et procédé de fabrication de celui-ci

(30) Priorität: 30.09.2008 DE 102008049672
(43) Veröffentlichungstag der Anmeldung: 31.03.2010
(73) Patentinhaber: Bruker EAS GmbH, 63450 Hanau (DE)
(72) Erfinder: Schlenga, Klaus, 76351 Linkenheim (DE); Szulczyk, Andreas, 63450 Linsengericht (DE)
(74) Vertreter: Patentanwälte Westphal, Mussgnug & Partner

(56) Entgegenhaltungen:
- EP-A- 1 569 285
- DE-A1- 2 331 962
- DE-A1-102006 020 829
- JP-A- 2007 095 367
- JP-A- 2008 066 168
- DERGUNOVA E A ET AL: "Development and Research of the Nb3Sn Superconductor With Improved Structure of Superconductive Layer" IEEE TRANSACTIONS ON APPLIED SUPERCONDUCTIVITY, IEEE SERVICE CENTER, LOS ALAMITOS, CA, US, Bd. 15, Nr. 2, 1. Juni 2005 (2005-06-01), Seiten 3407-3409, XP011134350 ISSN: 1051-8223
- GLOWACKI B A ET AL: "MgB2 conductors for dc and ac applications" PHYSICA C, NORTH-HOLLAND PUBLISHING, AMSTERDAM, NL, Bd. 372-376, 1. August 2002 (2002-08-01), Seiten 1235-1240, XP004375651 ISSN: 0921-4534
- HANCOCK M H ET AL: "Effect on Deformation Process of Adding a Copper Core to Multifilament Superconducting Wire" IEEE TRANSACTIONS ON APPLIED SUPERCONDUCTIVITY, IEEE SERVICE CENTER, LOS ALAMITOS, CA, US, Bd. 17, Nr. 2, 1. Juni 2007 (2007-06-01), Seiten 3054-3058, XP011188861 ISSN: 1051-8223
- TOMSIC ET AL: "Development of magnesium diboride (MgB2) wires and magnets using in situ strand fabrication method" PHYSICA C, NORTH-HOLLAND PUBLISHING, AMSTERDAM, NL, Bd. 456, Nr. 1-2, 1. Juni 2007 (2007-06-01), Seiten 203-208, XP022080832 ISSN: 0921-4534

## Beschreibung

Die Erfindung betrifft einen supraleitenden Verbund sowie ein Verfahren zum Herstellen derselben.

Verschiedene Arten von Supraleiter sind bekannt, die sich groß- technisch herstellen lassen. Legierungen NbTi und intermetallische Verbindungen Nb₃Sn weisen eine Sprungtemperatur T_{c} von weniger als 20K auf und können in großen Längen mittels klassischen Verformungsverfahren wie Strangpressen, Ziehen, Walzen hergestellt werden. Die niedrige Sprungtemperatur führt jedoch zu hohen Anlagen- und Kühlkosten.

Supraleitende kupferoxid-basierte Verbindungen, z.B. YBCO (T_{c} ca. 92K), Bi-2212 und Bi-2223 mit einer Sprungtemperatur von etwa 110K und Tl-2223 (T_{c} ca 125 K) sind auch bekannt. Diese Supraleiter werden als Hochtemperatur-Supraleiter "HTSL" bezeichnet. Die elektronischen Eigenschaften der HTSL sind durch die 2-dimensionale Vernetzung der CuO₂-Ebenen geprägt. Der zwei-dimensionale Charakter der CuO₂-Leitungsebenen spiegelt sich in extremem anisotropen physikalischer Eigenschaften wieder. So ist insbesondere die kritische Stromdichte J_{c} in den Leitern stark von der Feldrichtung eines ausgeprägten Magnetsfelds bestimmt.

Die supraleitende MgB₂-Phase sowie die MgB₂-basierten supraleitenden Phasen haben eine Sprungtemperatur von bis zu 40 K. Gegenüber den texturierten, kupfer-basierten technischen Lei~ tern zeigen MgB2-Leiter keine ausgeprägte Anisotropie der elektrischen Eigenschaften im aufgeprägten Magnetfeld.

Die MgB₂-Phase hat jedoch den Nachteil, dass sie wenig bis kein Umformvermögen in den klassischen Umformverfahren wie Walzen, Ziehen und Strangpressen aufweist. Die Herstellung großer Leiterlängen mit homogenen Leitereigenschaften für die Energietechnik ist mit klassischen Drahtherstellungsverfahren nicht einfach.

In der JP 2007 095 367 A ist ein Verfahren beschrieben, bei dem zunächst eine Anordnung hergestellt wird, die aufeinander folgend einen Kern aus Eisen-Magnesium, einen Mantel aus Bor sowie einen weiteren Mantel aus Eisen-Magnesium aufweist. Durch eine Wärmebehandlung bei einer Temperatur von 600°C bis 800°C diffundiert Magnesium aus dem Kern und dem weiteren Mantel in den Mantel aus Bor, so dass es dort zur Ausbildung einer MgB₂-Phase kommt.

Die DE 10 2006 020 829 A1 beschreibt einen Multifilament-Supraleiter, der mehrere supraleitfähige Filamente enthält, die in eine Matrix aus normalleitendem Material eingebettet sind. Als Material für die Filamente kommen alle bekannten LTC- oder HTC-Supraleitermaterialien wie z.B. MgB2 in Frage. Die Matrix besteht aus elementaren Materialien, oder aus Legierungen wie z.B. AgMg.

Aufgabe der Erfindung ist es, einen Supraleiter für den Einsatz in der Magnet- und Energietechnik sowie ein Verfahren zu dessen Herstellung anzugeben.

Gelöst wird die Aufgabe durch einen Verbund gemäß Ansprüchen lund 2 sowie durch ein Verfahren gemäß Anspruch 11. Vorteilhafte Weiterbildungen ergeben sich aus den davon abhängigen Ansprüchen.

Dabei wird ein Supraleiter auf MgB₂-Basis in Form eines Verbunds angegeben. In einem ersten Ausführungsbeispiel weist ein Verbund einen Kern aus einer supraleitenden MgB₂-Phase und einem ersten Mantel, der den Kern umhüllt, auf. Der erste Mantel besteht aus einer nicht supraleitenden Legierung, die Magnesium und zumindest Silber als ein weiteres Metall aufweist. Ein innerer Bereich des ersten Mantels, der den Kern umhüllt und an den der Kern grenzt, weist weniger Magnesium auf als ein äußerer Bereich des ersten Mantels, der den inneren Bereich des ersten Mantels umhüllt.

Dieser erste Verbund weist einen einzigen Kern auf, der zumindest eine supraleitende MgB₂-Phase hat. Der Mantel enthält Magnesium, das auch ein Element der supraleitenden MgB₂-Phase ist. Der innere Bereich des Mantels, der direkt an den Kern aus dem supraleitenden MgB₂-Material grenzt, weist dabei weniger Magnesium auf, als ein Bereich, der weiter entfernt vom Kern angeordnet ist.

Das MgB₂ Supraleitermaterial kann in einzelne MgB2-Filamente aufgeteilt werden, die in eine Matrix aus einer normalleitenden AgMg Legierung eingebettet ist. Dieser Multifilamentleiter ist ein Verbundwerkstoff, der aus dem eigentlichen supraleitenden Werkstoff, mit und ohne Barriere, dem Stabilisierungsmaterial und weiteren Komponenten zur mechanischen Verstärkung besteht. Erfindungsgemäß wird die supraleitende Phase des Kerns durch eine selektive Diffusionsreaktion zwischen einem Kern aus Bor oder aus einem borhaltigen, magnesium-armen Material und dem magnesiumhaltigen Mantel, der den Kern umhüllt, gebildet. Diese flächige Zusammensetzungsverteilung des ersten Mantels ist typisch für eine Reaktion aus zwei Elementen und das Resultat von einer eine Reaktion aus zwei Elementen, die vor der Reaktionen in zwei getrennte Bereiche nebeneinander angeordnet waren.

Der Verbund nach dem ersten Ausführungsbeispiel kann aus einem Vorprodukt hergestellt werden.

Das Vorprodukt ist ein Verbund, der einen Kern aus Bor oder einem borhaltigen, magnesium-armen Material und einen nicht supraleitenden ersten Mantel aufweist, der den Kern umhüllt. Der erste Mantel besteht aus einer Legierung, die Magnesium und Silber als weiteres Metall aufweist.

Unter einem borhaltigen, magnesium-armen Material wird eine Zusammensetzung verstanden, die einen geringeren Magnesiumgehalt aufweist als die stöichiometrische Zusammensetzung der supraleitenden Phase, d.h. 1 Mg : 2 B. Das borhaltige, magnesium-arme Material kann auch magnesium-frei sein.

Dieser Vorproduktverbund ermöglicht vor dem Erzeugen der supraleitenden MgB₂-Phase im Kern die Herstellung eines langen Drahts oder Bandes. Die supraleitende MgB₂-Phase wird folglich nicht verformt, da die supraleitende Phase erst am Schluss des Draht- oder Bandherstellungsverfahrens erzeugt wird. Nach dem Herstellen des Bandes bzw. des Drahts erfolgt eine Wärmebehandlung unter Schutzgas oder unter Vakuum, damit das Bor des Kerns und das Magnesium des Mantels miteinander chemisch reagieren. Durch diese Reaktion wird die supraleitende MgB₂-Phase im Kern des Verbunds gebildet.

Der Draht oder das Band kann in dem Ausgangszustand zunächst als Spule gewickelt und danach geglüht werden, um die supraleitende MgB₂-Phase im Kern der Spule zu erzeugen. Dieses Verfahren hat den Vorteil, dass nach dem Herstellen der supraleitenden Phase die Spule nur wenig oder gar nicht weiterbearbeitet werden muss. Beschädigungen an der supraleitenden Phase werden somit vermieden.

Ferner wird eine stoffschlüssige Verbindung zwischen der supraleitenden Phase und dem Mantel erzeugt. Dies hat den Vorteil, dass sich der Strom zwischen dem Kern und dem Mantel besser verteilen kann, so dass im Quenchfall das Risiko einer Beschädigung der supraleitenden Phase reduziert wird.

In einem zweiten Ausführungsbeispiel weist ein Verbund einen Kernbereich auf, der mehrere Filamente umfasst. Die Filamente weisen jeweils eine supraleitende MgB₂-Phase auf und sind von einem ersten Mantel aus einer nicht supraleitenden Legierung umhüllt. Der Kernbereich ist von einem zweiten Mantel aus einer nicht-supraleitenden Legierung umhüllt. Der erste Mantel und der zweite Mantel weisen Magnesium und zumindest ein weiteres Metall auf. Wie bei dem ersten Ausführungsbeispiel hat ein innerer Bereich des ersten Mantels, der die Filamente umhüllt und an die Filamente grenzt, weniger Magnesium als ein äußerer Bereich des ersten Mantels, der den inneren Bereich des ersten Mantels umhüllt.

Erster Mantel und zweiter Mantel sind im Verbund als getrenntes Teil nicht leicht erkennbar, wenn die Materialien der beiden Mäntel nach der Umformung miteinander verschweißt sind. Auch können die Materialien der beider Mäntel auf Grund der Wärmebehandlung zusammenschweißen, so dass eine Grenze zwischen beiden beispielsweise in einem Schliffbild nicht erkennbar ist.

In diesem Ausführungsbeispiel umhüllt zumindest ein Teil des inneren Bereichs die jeweiligen Filamente aus MgB₂. Der innere Bereich kann aus einem einzigen Bereich bestehen, der kontinuierlich die Filamente umhüllt. Alternativ kann der innere Bereich mehrere Teilbereiche aufweisen, die voneinander getrennt sind. Bei der ersten Ausführungsform kann der äußere Bereich aus getrennten Bereichen zwischen den Filamenten bestehen und der innere Bereich einteilig sein. Bei der zweiten Ausführungsform sind mehrere ringförmige innere Bereiche von ringförmigen äußeren Bereichen umhüllt.

Die Filamente aus einer supraleitenden MgB₂-Phase werden ebenfalls durch eine Reaktion zwischen den jeweiligen Filamenten aus Bor oder aus einem borhaltigen, magnesium-armen Material und dem magnesiumhaltigen Mantel, der die Filamente umhüllt, erzeugt. Wie beim ersten Ausführungsbeispiel ist die flächige Verteilung des Magnesiumsgehalts des ersten Mantels ein typisches Resultat einer Diffusionsreaktion aus zwei Elementen, die vor der Reaktion in großen getrennten nebeneinander angrenzenden Bereichen angeordnet waren.

Zur Herstellung eines supraleitenden Multifilamentverbunds nach einem der vorher beschriebenen Ausführungsbeispiele kann ein Vorprodukt verwendet werden. Dieser Verbund weist einen Kernbereich und einen ersten Mantel auf. Der Kernbereich weist mehrere Filamente aus Bor oder einem borhaltigen, magnesium-armen Material auf, die jeweils von dem ersten Mantel aus einer nicht supraleitenden Legierung umhüllt sind. Der Kernbereich ist wiederum von einem zweiten Mantel aus einer nicht-supraleitenden Legierung umhüllt. Der erste Mantel sowie der zweite Mantel bestehen aus einer Silber-Magnesium Legierung.

Mittels einer Wärmebehandlung können die borreichen, magnesiumarmen Filamente mit dem benachbarten magnesiumreichen, borarmen ersten Mantel reagieren, um die supraleitende MgB₂-Phase in den Filamenten zu bilden.

Zur elektromagnetischen Stabilisierung kann vorteilhaft ein hochleitfähiges Materiale integriert werden, das zum Schutz gegen Eindiffusion von Mg durch eine Diffusionsbarriere geschützt ist. Das hochleitfähige Material kann Cu oder Ag sein. Die Diffusionsbarriere kann aus den Elemente Ta, Nb, V, Hf oder Fe bestehen.

In einem weiteren Ausführungsbeispiel kann der Verbund nach einem der vorhergehenden Ausführungsbeispiele ferner eine mechanische Verstärkung aufweisen, damit die bei Hochstrom und Hochmagnetfeldern auftretenden Kräfte den Verbund und/oder die supraleitenden Eigenschaften nicht beschädigen oder zerstören.

Die mechanische Verstärkung wird beispielsweise in Form eines dritten Mantels vorgesehen. Dieser dritte Mantel kann als Au-βenmantel vorgesehen werden, der im Falle eines Monokernverbunds den ersten Mantel mit zwischengeschalteter Barriere umhüllt. Im Multifilamentverbund kann die mechanische Verstärkung auch als verstärkte Barriere (zum Beispiel Ta) bis 20% Querschnittsanteil ausgeführt werden.

In einem weiteren Ausführungsbeispiel hat die mechanische Verstärkung die Gestalt eines oder mehrere Stäbe. Diese Ausgestaltung des mechanischen Stabilisierungselements wird bei einem Multifilamentverbund verwendet. Die mechanischen Stabilisierungsstäbe werden beispielsweise im Kernbereich angeordnet und von dem ersten Mantel umhüllt. Der Stabilisierungsstab oder die Stäbe können den gleichen Durchmesser wie die Filamente aufweisen und regelmäßig, zum Beispiel axialsymmetrisch, in dem Filamentbild angeordnet werden. Die mechanischen Verstärkungsstäbe können zum Beispiel eine axialsymmetrische Anordnung im Filamentbild aufweisen, um die mechanische Stabilisierungswirkung bzw. Verstärkung über den Querschnitt des Verbunds gleichmäßiger zu verteilen.

Die mechanische Verstärkung in Gestalt von Stäben kann anstatt eines Stabilisierungselements in Gestalt eines Außenmantels realisiert werden. In einem weiteren Ausführungsbeispiel weist der Verbund eine mechanische Verstärkung im Au-βenmantel sowie mehrere mechanische Stabilisierungsstäbe im Kernbereich auf.

Auch bei Verstärkungsstäben kann eine Diffusionsbarriere zwischen den jeweiligen Verstärkungsstäben und dem ersten Mantel, in dem sie eingebettet sind, angeordnet werden. Die Diffusionsbarriere der Stäbe kann auch die Gestalt eines Rohrs haben.

Die Dicke der Diffusionsbarriere kann erhöht werden, um den Barrieren-Anteil zu erhöhen. Der Flächenanteil an der Diffusionsbarriere ist in einem Ausführungsbeispiel 3,5% bis 20% des Gesamtquerschnitts des Verbunds.

In ähnlicher Weise kann der Anteil an der elektromagnetischen Stabilisierung eingestellt werden. In einem Ausführungsbeispiel ist der Flächenanteil an der elektromagnetischen Stabilisierung 15% bis 50% des Gesamtverbundquerschnitts. Dieser Anteil kann durch die Dicke des Stabilisierungselements, und/oder die Zahl der Stabilisierungsstäbe und/oder die Zusammensetzung der Stabilisierungselemente eingestellt werden.

Die erfindungsgemäßen Verbünde haben typischerweise die Gestalt eines langen Körpers. Der Verbund kann dabei beispielsweise ein Draht oder als Band sein. In diesem Zusammenhang wird Draht als ein länglicher Körper mit einem ungefähr kreisförmigen oder elliptischen Querschnitt und ein Band als ein länglicher Körper mit einem ungefähr rechteckigen Querschnitt bezeichnet.

Bei einem Ausführungsbeispiel liegt vor dem Erzeugen der supraleitenden Phase der Magnesiumgehalt des ersten Mantels zwischen 5 Atom% und 40 Atom%. Nach dem Erzeugen der supraleitenden Phase liegt der Magnesiumgehalt des äußeren Bereichs des ersten Mantels zwischen 5 Atom% und 40 Atom%. Der Magnesiumgehalt des inneren Mantels ist nach dem Erzeugen der supraleitenden MgB₂-Phase geringer als vor dem Erzeugen der supraleitenden MgB₂-Phase.

Der Magnesiumgehalt kann darüber hinaus so gewählt werden, dass der Mantel mittels Verformungsverfahren wie Ziehen und Walzen ohne Rissbildung oder Zerreißen verformt werden kann.

Der Anteil an Magnesium kann auch so gewählt werden, dass ausreichend Magnesium vorhanden ist, um die supraleitende Phase aus dem Magnesium des Mantels und des Bors des Kerns zu erzeugen. Dieses Verhältnis kann auch durch die zusätzliche Maßnahme eingestellt werden, dass das Flächenverhältnis zwischen dem ersten magnesiumhaltigen Mantelanteil und dem borhaltigen Kernanteil eingestellt wird. In einem Ausführungsbeispiel liegt das Flächenverhältnis zwischen dem ersten Mantelanteil und dem Kernanteil zwischen 0,5 und 2.

Der erste Mantel und im Falle eines Multifilamentverbunds ferner der zweite Mantel ist eine Silber-Magnesium Legierung, wobei der Anteil an Magnesium zwischen 5 Atom% und 40 Atom% liegt.

Bei einem supraleitenden Verbund kann die flächige Verteilung der Elemente des ersten Mantels die Reaktionsart der supraleitenden Phasenbildung kennzeichnen. Erfindungsgemäß wird die supraleitende MgB₂-Phase durch die Reaktion des borreichen, magnesium-armen Kerns mit dem angrenzenden magnesium-reichen, bor-armen Mantel erzeugt. Folglich nimmt der Anteil an Magnesium des ersten Mantels nach dieser Reaktion vom äußeren Bereich bis zum Kern ab. Das Profil des Magnesiumgehalts kann typisch das eines Diffusionsprofils sein.

Bei einem Multifilamentverbund weist in einem weiteren Ausführungsbeispiel der zweite Mantel, der den ersten Mantel umhüllt, einen größeren Anteil an Magnesium als der erste Mantel auf. Der erste Mantel weist somit einen geringeren Magnesiumgehalt auf als der zweite Mantel. Dies kann das Ergebnis der Reaktion des Magnesiums des ersten Mantels mit dem borhaltigen Kern sein.

Bei einem Multifilamentverbund weist in einem weiteren Ausführungsbeispiel ein innerer Bereich des ersten Mantels, der die jeweiligen Filamente umhüllt und an den Filamenten grenzt, weniger Magnesium auf als ein äußerer Bereich des ersten Mantels, der den inneren Bereich des ersten Mantels umhüllt. Der Anteil an Magnesium kann auch vom äußeren Bereich bis zum Kern abnehmen und ein Diffusionsprofil aufweisen.

Die Erfindung gibt auch Verfahren zum Herstellen eines supraleitenden Verbunds an.

Erfindungsgemäß weist ein Verfahren zum Herstellen eines Verbunds an folgende Schritte auf. Ein Stab aus Bor oder einem borhaltigen magnesium-armen Material und ein erster Mantel aus einer Silber-Magnesium-Legierung werden bereitgestellt. Der stab wird mit dem ersten Mantel umhüllt und ein Verbund gebildet. Dieser Verbund kann als Vorprodukt eines supraleitenden Verbunds mit einem einzigen Kern sowie als Vorprodukt zum Herstellen eines Multifilamentverbunds dienen.

Wie oben bereits beschrieben weist der erste Mantel Silber und Magnesium auf. Außerdem liegt der Anteil des ersten Mantels an Magnesium zwischen 5 Atom% und 40 Atom%.

Nach dem Umhüllen des Stabes aus Bor oder einem borhaltigen, magnesium-armen Material mit dem ersten Mantel wird beispielsweise der Verbund unter Reduzieren des Querschnitts des Verbunds spanlos verformt. Die Länge des Verbunds wird dadurch vergrößert. Gleichzeitig kann zum Beispiel die Dichte des Stabes erhöht werden. Der Verbund kann mittels Hämmern, Strangpressen, Ziehen oder Walzen oder mit Kombinationen dieser Verfahren spanlos verformt werden.

Zum Herstellen eines supraleitenden Verbunds aus einem Vorprodukt wird der Verbund bei einer bestimmten Temperatur und über eine bestimmte Dauer geglüht. Temperatur und Dauer der Glühung werden so gewählt, dass der Stab aus Bor oder einem borhaltigen, magnesium-armen Material und das Magnesium des ersten Mantels eine supraleitende MgB₂-Phase bilden.

Es gibt mehrere Möglichkeiten den Stab aus Bor oder aus einem borhaltigen, magnesium-armen Material mit dem ersten Mantel zu umhüllen. Beispielsweise kann der Stab in ein Rohr aus der gewünschten Silber-Magnesium-Legierung eingeführt werden. Es kann aber auch der Stab in eine Folie gewickelt werden. Die Folie bildet dabei eine Umhüllung, die mehrere Lagen aufweisen kann.

Ebenso kann auch zunächst ein Bohrloch in ein Körperelement aus der Silber-Magnesium-Legierung eingebohrt werden. Anschließend wird ein Stab aus Bor oder einem borhaltigen, magnesium-armen Material in das Bohrloch eingeführt.

Die Erfindung gibt auch Verfahren zum Herstellen von Multifilamentverbünde an.

In einem ersten Ausführungsbeispiel hierzu werden mehrere Verbünde hergestellt, die jeweils zumindest einen Kern aus Bor oder einem borhaltigen, magnesium-armen Material und einem anderen Mantel aufweisen. Ein Verbund nach einem der vorherigen Ausführungsbeispiele kann ebenso verwendet werden. Diese Verbünde werden zu einem Bündel angeordnet, das mit einem zweiten Mantel umhüllt wird. Dieser Verbund kann weiter bearbeitet werden. Zum Beispiel kann dieser Verbund spanlos verformt werden, um die Länge des Verbunds zu erhöhen und gleichzeitig den Querschnitt zu reduzieren.

Zum Herstellen eines Multifilamentverbunds können zunächst mehrere Bohrlöcher in ein Körperelement aus der Silber-Magnesium-Legierung eingebohrt werden. Anschließend wird ein Stab aus Bor oder aus einem borhaltigen, magnesium-armen Material in die jeweiligen Bohrlöcher eingeführt, wobei ein Multifilamentverbund hergestellt wird.

Beispielsweise kann auch ein Stab aus einem Stabilisierungsmaterial in zumindest eines der Bohrlöcher eingeführt werden. Stäbe aus Bor oder aus einem borhaltigen, magnesium-armen Material werden in die übrigen Bohrungen eingeführt.

Auch kann nach dem Herstellen eines Multifilamentverbunds gemäß einem der vorher beschriebenen Ausführungsbeispiele der Multifilamentverbund unter Reduzierung des Querschnitts des Multifilamentverbunds spanlos verformt werden.

Das Multifilamentvorprodukt kann auch zum Bilden eines supraleitenden Verbunds verwendet werden. Hierzu wird der Multifilamentverbund bei einer bestimmten Temperatur und über eine bestimmte Dauer geglüht, die beide ausreichend sind, dass der Stab aus Bor oder einem borhaltigen, magnesium-armen Material und das Magnesium des ersten Mantels eine supraleitende MgB₂-Phase bilden.

Der Multifilamentverbund kann mit einem Stabilisierungselement in Gestalt eines Außenmantels versehen sein. Der Außenmantel kann als Rohr ausgeführt sein, in das der Multifilamentverbund eingeführt wird. Der Verbund kann auch nach diesem Schritt spanlos verformt werden.

Zum Herstellen eines Multifilamentverbunds mit mechanischen Stabilisierungselementen in Form von Stäben können die Stabilisierungsstäbe zusammen mit weiteren Verbünden mit einem aus Bor bestehen oder borhaltigen Kern gebündelt werden.

Wenn der Verbund eine Diffusionsbarriere aufweisen soll, wird diese zwischen dem Stabilisierungselement und dem zweiten Mantel eingefügt. Der zweite Mantel wird zunächst von der Diffusionsbarriere und danach die Diffusionsbarriere von dem dritten Mantel.

Beispielsweise weist die Diffusionsbarriere die Gestalt eines Rohrs auf. Dabei wird zunächst der zweite Mantel mit einem Diffusionsbarriererohr und anschließend das Diffusionsbarriererohr mit dem Stabilisierungselement umhüllt.

Durch spanloses Verformen wird der Verbund in die Gestalt eines Drahts oder eines Bandes gebracht. Das spanlose Verformen wird beispielsweise vor dem Erzeugen der supraleitenden Phase durchgeführt. Dies hat den Vorteil, dass kein Druck auf Grund des Verformungsverfahrens auf die supraleitende MgB₂-Phase ausgeübt wird und das Risiko von Rissen im supraleitenden Material verringert wird.

Der Draht bzw. das Band kann zu einer Spule gewickelt werden und zwar sowohl vor, als auch nach dem Erzeugen der supraleitenden Phase. Das Wickeln nach Erzeugen der supraleitenden Phase hat den Vorteil, dass Isolationsmaterial, das zwischen den elektrisch leitenden Wicklungen angeordnet ist, nicht aufgeheizt wird. Folglich ist die Isolation der Wicklungen einfacher und die Materialauswahl umfangreicher.

Das Wickeln eines Verbunds mit nicht supraleitender Phase bzw. eines Vorprodukts hat den Vorteil, dass keine mechanische Spannung auf die supraleitende Phase ausgeübt wird, da die supraleitende Phase erst nach dem Wickeln umgeformt wird. Folglich wird eine Rissbildung in den supraleitenden Filamenten weitgehend vermieden.

Die Erfindung wird nachfolgend anhand der Zeichnungen näher erläutert.
- Figur 1: ist eine schematische Darstellung eines Multifila- mentverbunds,
- Figur 2: ist eine schematische Darstellung eines Filaments des Verbunds der Figur 1 vor dem Erzeugen der sup- raleitenden Phase,
- Figur 3: ist eine schematische Darstellung eines Filaments des Verbunds der Figur 1 nach dem Erzeugen der sup- raleitenden Phase, und
- Figur 4: ist eine schematische Darstellung zweier Verfahren zum Herstellen eines Multifilamentverbunds mit der Anordnung der Figur 1.

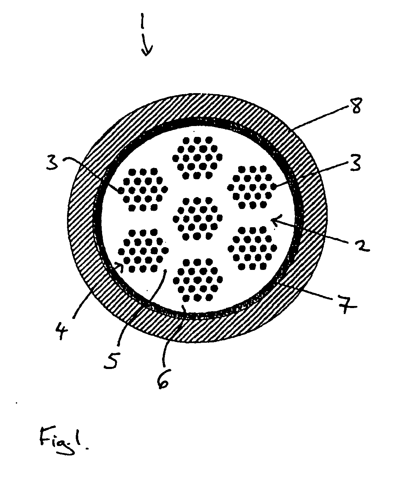

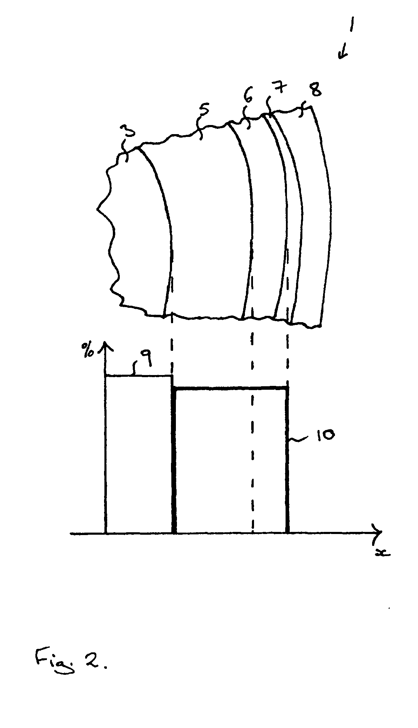

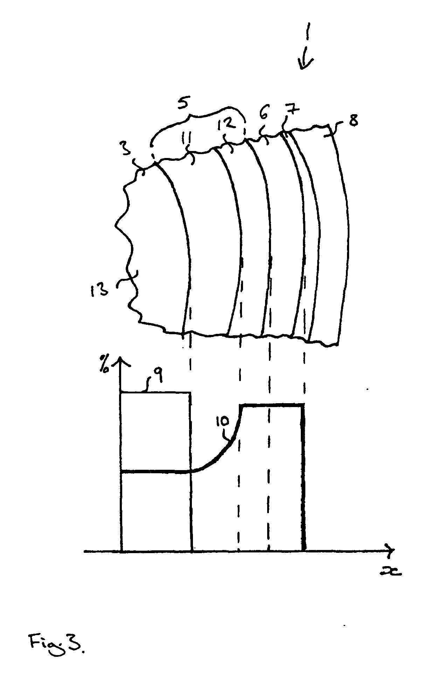

Figur 1 zeigt in einer schematischen Darstellung einen Querschnitt eines Multifilamentverbunds 1. Der Multifilamentverbund 1 weist einen Kernbereich 2 auf, in dem mehrere Filamente 3 eingebettet sind. Die Filamente 3 sind in sieben Gruppen 4 angeordnet, wobei die Filamente 3 der jeweiligen Gruppen 4 sowie die sieben Gruppen 4 in einem hexagonalen Muster angeordnet sind. Die Filamente 3 sind von einem ersten Mantel 5 umhüllt, der auch als eine Matrix bezeichnet wird, da alle Filamente 3 im ersten Mantel 5 eingebettet sind. Der erste Mantel 5 ist von einem zweiten Mantel 6 umhüllt. Der erste Mantel 5 und der zweite Mantel 6 sind in den Figuren 2 und 3 dargestellt.

Der Multifilamentverbund 1 weist eine Diffusionsbarriere 7 in Gestalt eines Rohrs auf, das den zweiten Mantel 6 umhüllt. Die Diffusionsbarriere 7 besteht im Wesentlichen aus Tantal oder Niob. Der Verbund 1 ist von einem rohrförmigen Außenmantel 8 aus Kupfer umhüllt, der als mechanisches Stabilisierungselement wirkt. Die Außenkontur des Verbunds 1 ist ungefähr kreisförmig. Die Außenkontur könnte aber auch ungefähr rechteckig sein.

Der Verbund 1 der Figur 1 weist keine supraleitende Phase auf und ist ein Vorprodukt, das dazu verwendet werden kann, einen supraleitenden Verbund mit einer supraleitenden MgB₂-Phase herzustellen.

Figur 2 zeigt einen Ausschnitt eines Filaments 3 sowie des ersten Mantels 5, des zweiten Mantels 6, der Diffusionsbarriere 7 und des Außenmantels 8 des Multifilamentverbunds 1 der Figur 1. Aus der grafischen Darstellung des Querschnitts des Multifilamentverbunds 1 ist die Zusammensetzung des Filaments 3, des ersten Mantels 5 sowie des zweiten Mantels 6 ersichtlich.

Das Filament 3 besteht im Wesentlichen aus Bor und der erste Mantel 5 besteht aus einer Silber-Magnesium-Legierung mit 20 Atom% Magnesium. Das Filament 3 ist somit im Wesentlichen Magnesium-frei und der erste Mantel 5 ist im Wesentlichen Bor-frei. Die zwei Elemente der zu bildenden supraleitenden MgB₂-Phase sind somit räumlich nebeneinander im Vorprodukt angeordnet. Der Mg-Konzentationsverlauf dieser Anordnung ist mit den Linien 9 und 10 in der Figur 2 dargestellt.

Die Linie 9 zeigt den Borgehalt des Verbunds 1 in x-Richtung und zeigt, dass Bor nur im Filament 3 enthalten ist. Die Linie 10 zeigt den Magnesiumgehalt des Verbunds 1 in x-Richtung, wobei Magnesium nur im ersten Mantel 5 und im zweiten Mantel 6 enthalten ist. Die zwei Elemente der zu bildenden supraleitenden MgB₂-Phase sind somit nebeneinander im Vorproduktverbund angeordnet.

Figur 3 zeigt den Ausschnitt des Verbunds 1 der Figur 2 nach einer Wärmebehandlung. Die Bedingungen der Wärmebehandlung werden so ausgewählt, dass sich die MgB₂-Phase in den borhaltigen Filamenten 3 durch Diffusionsreaktion von Mg aus dem magnesiumhaltigen Mantel 5, der die Filamente 3 umhüllt, bildet. Dies ist grafisch in der Figur 3 mit den Linien 9 und 10 dargestellt.

Die Linie 9 zeigt, dass Bor nur im Filament 3 enthalten ist. Die Linie 10 zeigt, dass Magnesium nicht nur in dem ersten Mantel 5 und dem zweiten Mantel 6, sondern auch im Filament 3 enthalten ist.

Im Gegensatz zum Vorprodukt der Figur 2 weist das Filament 3 nach der Wärmebehandlung Magnesium sowie Bor im Verhältnis MgB₂ auf und ist somit supraleitend. Der erste Mantel 5 hat nun zwei Bereiche 11, 12 unterschiedlichen Magnesiumgehalts. Der innere Bereich 11 grenzt an das Filament 3 an und weist weniger Magnesium auf als de äußere Bereich 12, der den inneren Bereich 11 umhüllt. Ein Vergleich der Figuren 2 und 3 zeigt, dass der Magnesiumgehalt des inneren Bereichs 11 geringer ist als der Magnesiumgehalt des inneren Bereichs 11 im Vorprodukt.

Der Magnesiumgehalt des ersten Mantels nimmt vom zweiten Bereich 12 bis zum Filament 3 ab. Die supraleitende MgB₂-Phase 13 bildet sich aus dem Magnesium des ersten Mantels 5, das zum Filamentkern 3 diffundiert und dort mit dem Bor des Filaments 3 chemisch reagiert. Auf Grund dieser Reaktionsweise weist die Verteilung des Magnesiums im inneren Bereich 11 des ersten Mantels ein Diffusionsprofil auf. Der zweite Bereich 12 hat einen Magnesiumanteil, der in diesem Ausführungsbeispiel ungefähr dem Magnesiumgehalt des zweiten Mantels 6 entspricht.

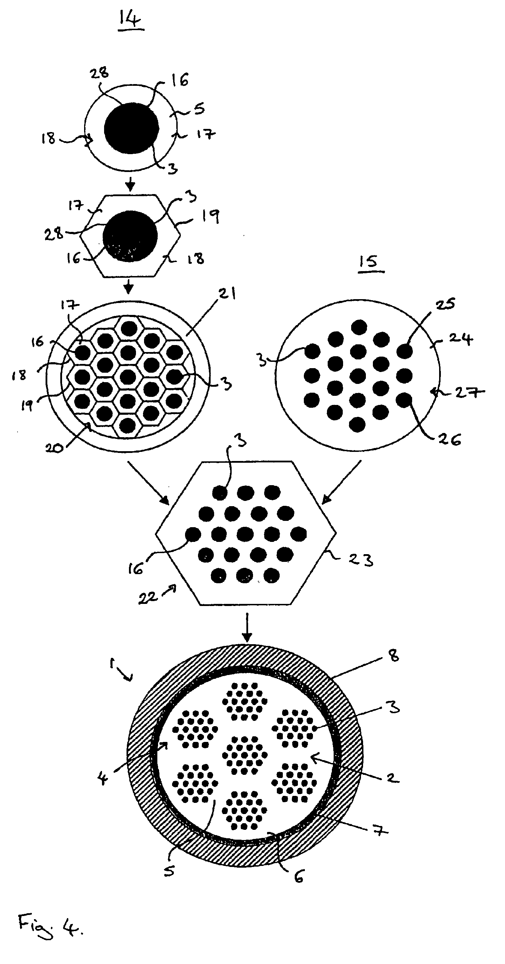

Figur 4 zeigt eine grafische Darstellung zweier Verfahren 14, 15 zum Herstellen eines Multifilamentverbunds 1 auf Basis der Anordnung der Figur 1.

In der ersten Ausführungsform 14 wird zunächst ein Stab 16 aus Bor in ein Rohr 17 mit einem kreisförmigen Querschnitt aus einer Silber-Magnesium-Legierung mit 20 Atom% Magnesium eingeführt. Diese Anordnung wird unter Reduzierung des Querschnitts und Verlängern verformt. Dies wird durch Ziehen und Hämmern mit eventuellen Zwischenglühungen durchgeführt, um einen Verbund 18 mit einem einzigen Kern 28 und einem ersten Mantel 5 herzustellen.

Der Verbund 18 dient in einem Ausführungsbeispiel als Endprodukt, wenn ein Verbund mit einem einzigen Kern 28, d.h. ein Monoleiter, gewünscht ist. Der Verbund 18 wird aufgeheizt, so dass das Bor des Kerns 28 mit dem Magnesium des ersten Mantels 5 chemisch reagiert und die supraleitende MgB₂ im Kern 28 erzeugt wird. Die flächige Verteilung des Borgehalts sowie des Magnesiumgehalts entspricht der Verteilung beim Multifilamentverbund 1, welche in der Figur 3 grafisch dargestellt ist. Der Mantel 5 weist einen in Figur 4 nicht gezeigten inneren Bereich 11 auf, der weniger Magnesium als ein nicht gezeigter äußerer Bereich 12 aufweist.

Der Verbund 18 kann auch als Zwischenprodukt beim Herstellen eines Multifilamentverbunds 22 dienen. Dieses Verfahren ist in der Figur 4 als Verfahren 14 bezeichnet.

Zum Herstellen eines Multifilamentverbunds 22 werden mehrere Verbünde 18 hergestellt und die Außenkonturen der Verbünde 18 in eine sechskantige Form 19 gebracht. Diese Außenform hat den Vorteil, dass die Verbünde 18 mit keinen oder wenigen Lücken zwischen den benachbarten Verbünden zu einem Bündel zusammengestellt werden können. Dieses Bündel 20 ist im nächsten Schritt dargestellt.

Das Bündel 20 aus neunzehn sechskantigen Verbünden 18 wird in einen weiteren Mantel 21 eingeführt und unter Reduzieren des Querschnitts verformt, um den Multifilamentverbund 22 mit neunzehn Filamenten 3 aus Bor zu bilden. Jeder Stab 16 sieht ein Filament 3 im Multifilamentverbund 22 vor. Dieser Multifilamentverbund 22 kann auch als Endprodukt mit neunzehn Filamenten 3 dienen oder kann noch weiterbearbeitet werden, um die Zahl der Filamente 3 weiter zu erhöhen wie beim Multifilamentverbund 1 der Figur 1.

Um den Verbund 1 zu bilden, werden sieben Verbünde 22, die jeweils neunzehn Filamente 3 und eine sechskantige Außenkontur 23 aufweisen, gebündelt und der Leeraum zwischen sechskant Bündlung und dem Innenradius mit an Schlüsselweite angepassten Profilen aus Silber-Magnesium-Legierung aufgefüllt.

Danach wird das Bündel von der Diffusionsbarriere 7 und dann vom Außenmantel 8 zur mechanischen Stabilisierung umhüllt und weiterverformt, um ein Vorprodukt eines Multifilamentverbunds 1 mit sieben Gruppen 4 mit neunzehn Filamenten 3 aus Bor zu bilden. Anschließend wird der Verbund 1 geglüht, um die supraleitende MgB₂-Phase 13 in den Filamenten 3 zu erzeugen. Die flächige Verteilung des Magnesiums im ersten Mantel 5 entspricht der Magnesiumverteilung in Figur 1 gezeigten.

In einem weiteren Ausführungsbeispiel wird der Multifilamentverbund 1 mit dem folgenden Verfahren 15 hergestellt, das auch in der Figur 4 grafisch dargestellt ist. Zunächst wird ein Zylinderkörper 24 aus einer Silber-Magnesium-Legierung mit einem Magnesiumgehalt von 25 Atom% bereitgestellt und mehrere Bohrungen 25 in den Zylinderkörper 24 eingebohrt. Die Anordnung der Bohrungen 25 entspricht dem hexagonalen Muster des Verbunds 22 beim Verfahren 14.

Stäbe 26 aus Bor oder einem borhaltigen Material werden in diese Bohrungen 25 eingeführt, um einen Verbund 27 mit neuenzehn Filamenten 3 herzustellen. Danach wird der Verbund 27 unter Reduzieren des Querschnitts und Verlängern spanlos verformt. Dieser Verbund 27 kann auch als Endprodukt dienen.

In einem weiteren Ausführungsbeispiel werden mehrere dieser Verbünde 27 mit einer sechskantigen Außenkontur 23 versehen und zu einem Bündel zusammengestellt. Wie oben bereits dargelegt wird das Bündel mit Diffusionsbarriere 7 und einem mechanischen Stabilisierungsmantel 8 umhüllt, und weiter verformt, um Multifilamentverbund 1 herzustellen. Der Multifilamentverbund 1 wird einer Wärmebehandlung unterzogen, um eine supraleitende MgB₂-Phase 13 in den Filamenten 3 zu erzeugen, wie in der Figur 3 dargestellt ist.

In einem weiteren, in den Zeichnungen nicht gezeigten Ausführungsbeispiel eines Multifilamentverbunds wird die mechanische Stabilisierung durch mehrere mechanische Stabilisierungsstäbe erreicht, die die Größe der Stäbe aus Bor haben. Bei dem Verfahren 14 sowie dem Verfahren 15 ersetzen die mechanischen Stabilisierungsstäbe einige Stäbe aus Bor im Bündel 20. Die mechanischen Stabilisierungsstäbe können im Bündel 20 mit axial-symmetrischem Muster angeordnet werden, um die Stabilisierungswirkung gleichmäßiger über den Verbundquerschnitt zu verteilen. Der Multifilamentverbund kann nicht nur Stabilisierungsstäbe im Kernbereich aufweisen, sondern auch ein weiteres Stabilisierungselement in Form eines Außenmantels aufweisen.

In einem weiteren Ausführungsbeispiel werden Formkörper in Gestalt von Stäben aus amorphen Borpulver durch Verdichtung bei 1000 bar hergestellt. Diese Formkörper weisen einen Durchmesser von 15 mm und eine Länge von 100 mm auf. Ein Formkörper wird in ein Rohr aus einer AgMg-Legierung mit 20 Atom% Mg mit einem Innendruchmesser von 16 mm, Außendurchmesser von 24 mm und einer Länge von 2000 mm eingeführt. Ein Rohrende wird mit einem Endstopfen aus Ag orbital unter Schutzgas verschweißt. An dem anderen Ende wird ein Abpumpstopfen eingeschweißt.

Der Monoleiter wird unter Schutzgas in Temperaturen von 300°C bis zu 600°C ausgeheizt und abgepumpt. Nach dem Ausheizen und Abquetschen der Saugleitung wird der Monoleiter durch Hämmern und Ziehen mit alternierender Wärmebehandlung zu Kernleitern und Vorleiter für die Fertigung eines Verbunds 1 nach Figur 1 umgeformt. Bei einem Filamentdurchmesser von 151 µm im Fertigleiter wird durch Diffusionsglühen mit Zeit- und Temperaturrampen zwischen 500°C bis zu 800°C in einer Schutzgasatmosphäre oder Vakuum die supraleitende MgB₂-Phase aus dem Bor der Filamente und dem Magnesium der Matrix gebildet.

In einem weiteren Ausführungsbeispiel wird ein Formkörper für einen Vorleiter aus einer AgMg-Legierung mit 25 Atom% Magnesium mit 19 Tieflöchern gebohrt. Das Bohrbild wird so eingestellt, dass ein lokales Flächenverhältnis von Metall zu Loch 1,3 beträgt und das Verhältnis der Gesamtfläche von Metall zu Löcher ca. 3 beträgt. Bor wird in die Löcher eingeführt, so dass das lokale Flächenverhältnis von Metall zu Bor 1,3 und das Verhältnis der Gesamtfläche von Metall zu Bor 3 beträgt.

Dieser Verbundkörper wird auf die gewünschte Schlüsselweite umgeformt. Sieben profilierte Vorleiterstäbe werden mit einem Bündelbild von 7 x 19 gebündelt. Das Bündel weist somit 133 Filamente aus Bor bzw. MgB₂ auf.

Eine Diffusionsbarriere aus Tantal, die 6% der Gesamtquerschnittsfläche beträgt, und eine mechanische Stabilisierung aus Kupfer mit einer Fläche von 23% der Gesamtquerschnittsfläche werden vorgesehen. Eine Ausheizbehandlung bei einer Temperatur von bis zu 350°C wird durchgeführt. In einem anderen Ausführungsbeispiel kann die Ausheizbehandlung ausgelassen werden.

Der Verbund mit der Diffusionsbarriere und dem mechanischen Stabilisierungsrohr wird mit Hämmern, Ziehen und Walzen mit zwischengeschalteten Wärmebehandlungen zu einem Profildraht mit einem Durchmesser von 1,5 mm bis 2 mm umgeformt. Der Filamentdurchmesser ist ungefähr 64 µm.

Der Draht wird anschließend mit Zeit- und Temperaturrampen zwischen 600°C und 750°C geglüht, um eine Diffusionsreaktion zwischen dem Magnesium der Matrix und dem Bor der Filamente zu erzeugen. Die Borfilamente werden auf Grund der Diffusion des Magnesiums aus der Matrix in die supraleitende Phase MgB₂ übergeführt.

Wie oben bereits ausgeführt kann der Verbund 1 also eine mechanische Stabilisierung 8 aufweisen. Dabei kann der flächige Anteil der mechanischen Stabilisierung 8 zum Beispiel 15% bis 50% des Gesamtquerschnitts des Verbunds 1 betragen. Der Verbund 1 kann die Gestalt eines Drahts oder eines Bandes haben.

Es kann auch vorgesehen werden, dass der Magnesiumgehalt im ersten Mantel ausgehend vom äußeren Bereich 12 zum inneren Bereich hin abnimmt und ein Diffusionsprofil aufweist, wobei das Flächenverhältnis von erstem Mantel 5 zu Kern 28 bzw. zu einzelnem Filament zwischen 0,5 und 2 liegen kann.

Der erste Mantel 5 undder zweite Mantel 6 weisen Silber und Magnesium aufweisen, wobei der erste Mantel 5 insgesamt weniger Magnesium als der zweite Mantel 6 aufweisen kann. Insbesondere kann der innere Bereich des ersten Mantels 2-10 Atom% Mg aufweisen.

Beim erfindungsgemäßen Verfahren kann insbesondere zum Umhüllen des Stabes 16 der Stab in ein Rohr 17 aus einer Silber-Magnesium Legierung eingeführt werden. Es können zum Umhüllen des Stabes 26 für sich oder zudem zunächst mehrere Bohrlöcher 25 in einem Körperelement 24 aus einer Silber-Magnesium Legierung eingebohrt werden, wobei anschließend ein Stab 26 aus Bor oder einem borhaltigen, magnesium-armen Material mindestens in ein Bohrloch 25 eingeführt wird.

Ferner können mehrere Verbünde 18 hergestellt werden, die zu einem Bündel 20 angeordnet werden, das mit einem zweiten Mantel 21 umhüllt wird, wobei ein Multifilamentverbund 22 hergestellt wird. Es können auch zunächst mehrere Bohrlöcher 25 in einem Körperelement 24 aus einer Silber-Magnesium Legierung eingebohrt werden, wobei anschließend ein Stab 26 aus Bor oder einem borhaltigen, magnesium-armen Material in die jeweiligen Bohrlöcher 25 eingeführt wird, so dass ein Multifilamentverbund 22 geschaffen wird. Nach dem Herstellen des Multifilamentverbunds 22 kann der Multifilamentverbund 22 unter Reduzierung des Querschnitts des Multifilamentverbunds spanlos verformt werden.

Es ist weiterhin vorgesehen, dass der Multifilamentverbund 22 bei einer Temperatur und einer Dauer geglüht wird, die ausreichend sind, dass sich aus dem Stab 16, 26 aus Bor oder einem borhaltigen, magnesium-armen Material und aus dem Magnesium des ersten Mantels 17, 24 eine supraleitende MgB₂-Phase ausgebildet wird. Ferner kann der Verbund 1 mit einem Stabilisierungselement 8 in Gestalt eines dritten Mantels umhüllt werden.

Schließlich kann vorgesehen werden, dass zusammen mit den Stäben 16, 26 aus Bor oder einem borhaltigen, magnesium-armen Material Stabilisierungelemente in Gestalt von Stäben gebündelt werden, zwischen dem Stabilisierungselement 8 und dem zweiten Mantel 6 eine Diffusionsbarriere 7 eingefügt wird und die Diffusionsbarriere 7 als Rohr ausgebildet wird, wobei zunächst der zweite Mantel 6 mit der Diffusionsbarriere 7 umhüllt wird, und anschließend die Diffusionsbarriere 7 mit dem Stabilisierungselement 8 umhüllt wird.

## Patentansprüche

1. Verbund (18) mit einem Kern (28) aus einer supraleitenden Phase (13) und einem ersten Mantel (5), der den Kern (28) umhüllt, wobei
der erste Mantel (5) aus einer nicht supraleitenden Legierung besteht, die Magnesium und zumindest ein weiteres Metall enthält,
der Kern (28) eine supraleitende MgB₂-Phase (13) aufweist,
ein innerer Bereich (11) des ersten Mantels (5), der den Kern (28) umhüllt und an diesen grenzt, weniger Magnesium aufweist als ein äußerer Bereich (12) des ersten Mantels (5), der den inneren Bereich (11) des ersten Mantels (5) umhüllt, und
der äußere Bereich (12) zwischen 5 und 40 Atom% Mg enthält, **dadurch gekennzeichnet, dass** die nicht supraleitende Legierung, aus der der erste Mantel (5) besteht, eine Silber-Magnesium-Legierung ist.

2. Verbund (1) mit einem mehrere Filamente (3) aufweisenden Kernbereich (2), wobei
die Filamente jeweils eine supraleitende Phase (13) aufweisen und von einem ersten Mantel (5) aus einer nicht supraleitenden Legierung umhüllt sind,
der Kernbereich (2) von einem zweiten Mantel (6) aus einer nicht-supraleitenden Legierung umhüllt ist, wobei der erste Mantel (5) und der zweite Mantel (6) Magnesium und zumindest ein weiteres Metall aufweisen,
**dadurch gekennzeichnet, dass**
ein innerer Bereich (11) des ersten Mantels (5), der die Filamente (3) umhüllt und an die Filamente (3) grenzt, weniger Magnesium aufweist als ein äußerer Bereich (12) des ersten Mantels (5), der den inneren Bereich (11) des ersten Mantels (5) umhüllt,
der äußere Bereich zwischen 5 und 40 Atom% Mg enthält,
wobei die jeweils eine supraleitende Phase MgB₂ ist; und die nacht supraleitenden Legierungen, aus denen der erste Mantel (5) und der zweite Mantel (6) bestehen, Silber-Magnesium-Legierungen sind.

3. Verbund (1) nach einem der vorhergehenden Ansprüche, wobei der Verbund (1) ferner eine mechanische Stabilisierung (8) aufweist.

4. Verbund (1) nach Anspruch 3, wobei die mechanische Stabilisierung (8) als dritter Mantel ausgebildet ist.

5. Verbund (1) nach einem der Ansprüche 3 oder 4, wobei zwischen der mechanischen Stabilisierung (8) und dem ersten Mantel (5) eine Diffusionsbarriere (7) angeordnet ist.

6. Verbund (1) nach einem der Ansprüche 3 bis 5, wobei zwischen der mechanischen Stabilisierung (8) und dem zweiten Mantel (5) eine Diffusionsbarriere (7) angeordnet ist.

7. Verbund (1) nach einem der Ansprüche 3 bis 6, wobei die mechanische Stabilisierung (8) einen oder mehrere Stäbe aufweist, die von dem ersten Mantel (5) umhüllt sind.

8. Verbund (1) nach einem der Ansprüche 5 bis 7, wobei die Diffusionsbarriere (7) eines oder mehrere der Elemente Nb, Ta und V aufweist.

9. Verbund (1) nach einem der Ansprüche 5 bis 8, wobei der flächige Anteil der Diffusionsbarriere (7) 3% bis 20% des Gesamtquerschnitts des Verbunds (1) beträgt.

10. Verbund (1) nach einem der Ansprüche 3 bis 9, wobei die mechanische Stabilisierung (8) Cu oder Ag aufweist.

11. Verfahren zum Herstellen eines Verbunds (1; 18; 22) nach Anspruch 1 oder 2, das folgende Schritte aufweist:
Bereitstellen eines Stabes (16) aus Bor oder einem borhaltigen, magnesium-armen Material,
Bereitstellen eines ersten Mantels (17) aus einer Silber-Magnesium-Legierung mit einem Magnesium Gehalt zwischen 5 und 40 Atom %.
Umhüllen des Stabes (16) mit dem ersten Mantel (17) zum Bilden eines Verbunds (18).

12. Verfahren nach Anspruch 11, wobei ferner der Verbund (18) unter Reduzieren des Querschnitts des Verbunds spanlos verformt wird.

13. Verfahren nach Anspruch 11 oder 12, wobei der Verbund (18) bei einer Temperatur und einer Dauer geglüht wird, die ausreichend sind, dass sich aus dem Stab (16) aus Bor oder aus einem borhaltigen, magnesium-armen Material und aus dem Magnesium des ersten Mantels (17) eine supraleitende MgB₂-Phase (13) bildet.

## Claims

1. Composite (18) with a core (28) made of a superconducting phase (13) and a first jacket (5) which encloses the core (28), wherein
the first jacket (5) consists of a nonsuperconducting alloy which contains magnesium and at least one additional metal,
the core (28) comprises a superconducting MgB₂ phase (13),
an inner region (11) of the first jacket (5), which encloses the core (28) and abuts against the latter, comprises less magnesium than an outer region (12) of the first jacket (5), which encloses the inner region (11) of the first jacket (5),
and
the outer region (12) contains between 5 and 40 atom% Mg,
**characterized in that**, that the nonsuperconducting alloy, of which the first jacket (5) consists, is a silver-magnesium alloy.

2. Composite (1) with a core region (2) comprising several filaments (3), wherein
the filaments each comprise a superconducting phase (13) and are enclosed by a first jacket (5) made of a nonsuperconducting alloy,
the core region (2) is enclosed by a second jacket (6) made of a nonsuperconducting alloy, wherein the first jacket (5) and the second jacket (6) comprise magnesium and at least one additional metal, **characterized in that**
an inner region (11) of the first jacket (5), which encloses the filaments (3) and abuts against the filaments (3), comprises less magnesium than an outer region (12) of the first jacket (5), which encloses the inner region (11) of the first jacket (5),
the outer region contains between 5 and 40 atom% Mg,
wherein in each case the one superconducting phase is MgB₂; and the nonsuperconducting alloys, of which the first jacket (5) and the second jacket (6) consist, are silver-magnesium alloys.

3. Composite (1) according to one of the previous claims, wherein the composite (1) furthermore comprises mechanical stabilization (8).

4. Composite (1) according to Claim 3, wherein the mechanical stabilization (8) is configured as a third jacket.

5. Composite (1) according to one of Claims 3 or 4, wherein a diffusion barrier (7) is arranged between the mechanical stabilization (8) and the first jacket (5).

6. Composite (1) according to one of Claims 3-5, wherein a diffusion barrier (7) is arranged between the mechanical stabilization (8) and the second jacket (5).

7. Composite (1) according to one of Claims 3-6, wherein the mechanical stabilization (8) comprises one or more rods which are enclosed by the first jacket (5).

8. Composite (1) according to one of Claims 5-7, wherein the diffusion barrier (7) comprises one or more of the elements Nb, Ta and V.

9. Composite (1) according to one of Claims 5-8, wherein the flat portion of the diffusion barrier (7) is 3-20% of the total cross section of the composite (1).

10. Composite (1) according to one of Claims 3-9, wherein the mechanical stabilization (8) comprises Cu or Ag.

11. Method for producing a compound (1; 18; 22) according to Claim 1 or 2, which comprises the following steps:
preparing a rod (16) made of boron or of a boron-containing, low-magnesium material,
preparing a first jacket (17) made of a silver-magnesium alloy with a magnesium content between 5 and 40 atom%, and
enclosing the rod (16) with the first jacket (17) to form a composite (18).

12. Method according to Claim 11, wherein, furthermore, the composite (18) is deformed in a non-cutting manner with reduction of the cross section of the composite.

13. Method according to Claim 11 or 12, wherein the composite (18) is annealed at a temperature and for a duration which are sufficient so that a superconducting MgB₂ phase (13) forms from the rod (16) made of boron or of a boron-containing, low-magnesium material and from the magnesium of the first jacket (17).

## Revendications

1. Composite (18) comprenant un coeur (28) fait d'une phase supraconductrice (13) et d'une première enveloppe (5) qui renferme le coeur (28), dans lequel
la première enveloppe (5) est constituée d'un alliage non supraconducteur qui contient du magnésium et au moins un métal supplémentaire
le coeur (28) comprend une phase supraconductrice de MgB₂ (13),
une région interne (11) de la première enveloppe (5), qui renferme le coeur (28) et s'applique contre ce dernier, comprend moins de magnésium qu'une région externe (12) de la première enveloppe (5), qui renferme la région interne (11) de la première enveloppe (5),
et
la région externe (12) contient entre 5 et 40 % atomique de Mg
**caractérisé en ce que** l'alliage non supraconducteur, avec lequel est constituée la première enveloppe (5), est un alliage argent-magnésium.

2. Composite (1) comprenant une région de coeur (2) comprenant plusieurs filaments (3), dans lequel
les filaments comprennent chacun une phase supraconductrice (13) et sont renfermés par une première enveloppe (5) faite d'un alliage non supraconducteur,
la région de coeur (2) est renfermée par une deuxième enveloppe (6) faite d'un alliage non supraconducteur, dans lequel la première enveloppe (5) et la deuxième enveloppe (6) comprennent du magnésium et au moins un métal supplémentaire, **caractérisé en ce que**
une région interne (11) de la première enveloppe (5), qui renferme les filaments (3) et s'applique contre les filaments (3), comprend moins de magnésium qu'une région externe (12) de la première enveloppe (5), qui renferme la région interne (11) de la première enveloppe (5)
la région externe contient entre 5 et 40 % atomique de Mg,
dans lequel, dans chaque cas, la phase supraconductrice est du MgB₂ ; et les alliages non supraconducteurs, avec lesquels sont constituées la première enveloppe (5) et la deuxième enveloppe (6), sont des alliages argent-magnésium.

3. Composite (1) selon l'une des revendications précédentes, le composite (1) comprenant en outre une stabilisation mécanique (8).

4. Composite (1) selon la revendication 3, dans lequel la stabilisation mécanique (8) est conçue sous forme d'une troisième enveloppe.

5. Composite (1) selon l'une des revendications 3 ou 4, dans lequel une barrière de diffusion (7) est disposée entre la stabilisation mécanique (8) et la première enveloppe (5).

6. Composite (1) selon l'une des revendications 3 à 5, dans lequel une barrière de diffusion (7) est disposée entre la stabilisation mécanique (8) et la deuxième enveloppe (6).

7. Composite (1) selon l'une des revendications 3 à 6, dans lequel la stabilisation mécanique (8) comprend une ou plusieurs tiges qui sont renfermées par la première enveloppe (5).

8. Composite (1) selon l'une des revendications 5 à 7, dans lequel une barrière de diffusion (7) comprend un ou plusieurs des éléments Nb, Ta et V.

9. Composite (1) selon l'une des revendications 5 à 8, dans lequel la partie plate de la barrière de diffusion (7) constitue 3-20 % de la section transversale totale du composite (1).

10. Composite (1) selon l'une des revendications 3 ou 9, dans lequel la stabilisation mécanique (8) comprend du Cu ou de l'Ag.

11. Procédé de production d'un composé (1 ; 18 ; 22) selon la revendication 1 ou 2, qui comprend les étapes suivantes consistant à :
préparer une tige (16) faite de bore ou d'un matériau à faible teneur en magnésium contenant du bore,
préparer une première enveloppe (17) faite d'un alliage argent-magnésium avec une teneur en magnésium comprise entre 5 et 40 % atomique, et
enfermer la tige (16) avec la première enveloppe (17) pour former un composite (18).

12. Procédé selon la revendication 11, dans lequel, en outre, le composite (18) est déformé de manière non coupante avec réduction de la section transversale du composite.

13. Procédé selon la revendication 11 ou 12, dans lequel, le composite (18) est recuit à une température et pendant une durée qui sont suffisantes pour que la phase supraconductrice de MgB₂ (13) se forme à partir de la tige (16) faite de bore ou d'un métal à faible teneur en magnésium contenant du bore, et du magnésium de la première enveloppe (17).
